(19) Europäisches Patentamt / European Patent Office / Office européen des brevets

(11) **EP 4 509 639 A1**

(12) **EUROPEAN PATENT APPLICATION**
published in accordance with Art. 153(4) EPC

(43) Date of publication:
19.02.2025 Bulletin 2025/08

(21) Application number: 23787460.7

(22) Date of filing: 15.03.2023

(51) International Patent Classification (IPC):
*C23C 16/513* (2006.01)    *C23C 16/52* (2006.01)

(52) Cooperative Patent Classification (CPC):
C23C 14/12; C23C 14/24; C23C 16/26;
C23C 16/50; C23C 16/513; C23C 16/52;
C23C 28/00; G06F 3/041

(86) International application number:
PCT/CN2023/081532

(87) International publication number:
WO 2023/197812 (19.10.2023 Gazette 2023/42)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 15.04.2022  CN 202210395178

(71) Applicant: Jiangsu Favored Nanotechnology Co.,
Ltd.
Wuxi, Jiangsu 214111 (CN)

(72) Inventor: ZONG, Jian
Wuxi, Jiangsu 214111 (CN)

(74) Representative: Mewburn Ellis LLP
Aurora Building
Counterslip
Bristol BS1 6BX (GB)

(54) **DLC COATING AND PREPARATION METHOD AND DEVICE THEREFOR, COMPOSITE COATING LAYER AND COATED PRODUCT**

(57)    A DLC coating layer and a preparation method and device therefor, a composite coating layer and a coated product. The DLC coating layer is obtained by the deposition of a hydrocarbon monomer and a silane monomer via a PECVD method. A hydrocarbon monomer and a silane monomer may undergo reaction and deposition at room temperature to form a coating, such that the influence of a relatively high temperature of a conventional coating manner on the performance of a substrate is effectively avoided. The formed DLC coating has the characteristics of a low color difference, high transparency and high bonding strength; and a preparation method therefor is simple, which is conductive to process production. Moreover, a composite coating layer obtained by depositing an AF coating on the DLC coating has the characteristics of a low color difference, high transparency, and better scratch resistance, and is particularly suitable for coated products such as a touch panel.

**Figure 1**

EP 4 509 639 A1

# EP 4 509 639 A1

**Description**

This application claims the benefit of priority to Chinese Patent Application No. 202210395178.5, filed on April 15, 2022 with China National Intellectual Property Administration, and entitled "DLC COATING AND PREPARATION METHOD AND DEVICE THEREFOR, COMPOSITE COATINGLAYER AND COATED PRODUCT", the entire disclosure of which is incorporated herein by reference.

TECHNICAL FIELD

The present disclosure relates to the field of chemical coating, and particularly, to a DLC coating, a method and device for preparing the same, a composite coating, and a coated product.

BACKGROUND

In recent years, with continuous updating of Internet technology and industrial manufacturing technology, people's daily life has entered the multimedia era, where the touch control screens and various novel wearable electronic devices are ubiquitous in the life and workplace, which has brought great interest and convenience to daily life and work. With the popularity of touch control, its own characteristics of easy to be scratched and to adhere to fingerprints, on the one hand affect the appearance, and on the other hand, will also affect use of functions and bring poor user experience, so it is necessary to form a layer of AF (anti-fingerprint) coating on a surface of a touch control screens. In this regard, Japanese Daikin proposed technology of evaporating fluorinated pills, which has brought great improvement in wear resistance and anti-fingerprint, and has been widely recognized in the industry. However, with increasing demand for use and updates of application scenarios, wear-resistant requirements for smart touch panels are increasingly improving, and original technical bottlenecks need to be broken.

DLC (diamond-like coating) coating is a hybrid of allotropes of carbon, and has a property of combined hardness and wear-resistance of diamond and flexibility and lubricity of graphite, which vests DLC coating a wide range of application possibilities. However, in touch panels (PC, glass, PMMA, etc.), there are two main problems that limit application of DLC coating. One problem is that the coating has color difference, which affects light transmittance. The other problem is bond strength thereof, which needs to be paid attention to upon bonding with a substrate and a subsequently coated oleophobic layer. In recent years, researchers have improved comprehensive properties of a DLC coating by doping new elements mainly, Ti, Cr, Zr, Si, N, etc., thereinto. For example, a diamond-like coating with a relatively low friction coefficient can be obtained by preparing a silicon-doped DLC coating through DC magnetron sputtering, intermediate frequency magnetron sputtering and ion source-assisted deposition. For this method, on the one hand, multiple discharge modes need to be compounded at the same time, and the equipment is relatively complex in structure and high in manufacturing cost; and on the other hand, coating is performed at a temperature greater than 150 °C, and deposition is performed at a temperature higher than the maximum heat deflection temperatures of conventional touch panel materials, such as, PMMA, PC and other polymer materials, which cannot meet industrial and stable production requirements in the field of touch panels.

SUMMARY

Embodiments of the present disclosure provide a DLC coating with low color difference, high transparency and high bond strength that is simply prepared by a PECVD (Plasma Enhanced Chemical Vapor Deposition) method and is conducive to process production, and an anti-fingerprint composite coating with low color difference, high transparency and more scratch resistance prepared thereby.

Specifically, embodiments of the present disclosure provide a DLC coating formed from a hydrocarbon monomer with a formula of $C_{x1}H_{y1}$ and a silane monomer with a formula of $C_{x2}H_{y2}Si_z$ by deposition through a PECVD method, and, x1 is an integer from 1 to 10, y1 is an integer from 2 to 22, x2 is an integer from 0 to 32, y2 is an integer from 4 to 68, and z is an integer from 1 to 4.

According to some embodiments, the hydrocarbon monomer and the silane monomer have boiling points below 100 °C at atmospheric pressure.

According to some embodiments, the hydrocarbon monomer may be methane, acetylene, benzene or ethylene.

According to some embodiments, the silane monomer may be silicon tetrahydride, methylsilane, dimethylsilane, trimethylsilane, tetramethylsilane, ethyl silane or diethylsilane.

According to some embodiments, the hydrocarbon monomer has a molar ratio of 60:40 to 95:5 to the silane monomer.

According to some embodiments, the DLC coating has a thickness of 5 nm to 100 nm.

Embodiments of the present disclosure further provide an apparatus for preparing the above DLC coating, which includes:

a plasma reactor for forming a DLC coating by deposition through a PECVD method;

a monomer vaporization control device for heating to vaporize the hydrocarbon monomer in liquid form at room temperature or controlling a vaporization state of the silane monomer;

a gas flowmeter for metering a flow rate of the monomers that have been vaporized in a controlled manner; and

a thermal insulation device for insulating a flow line of the monomers to ensure that a vaporized monomer in the monomer vaporization control device may be stably introduced into the plasma reactor.

According to some embodiments, the apparatus further includes a pressure gauge provided between the monomer vaporization control device and the gas flowmeter, and a temperature of the monomer vaporization control device may be controlled based on a reading of the pressure gauge.

Embodiments of the present disclosure further provide a method for preparing the above DLC coating, which includes the following steps:

providing a substrate and placing it in a plasma reactor;

metering a gas of the hydrocarbon monomer and a gas of the silane monomer and introducing them into the plasma reactor, and turning on a bias power supply, to deposit the DLC coating on the substrate by a PECVD method.

According to some embodiments, the hydrocarbon monomer and the silane monomer are respectively metered by the gas flowmeter and introduced in a form of gas.

According to some embodiments, a temperature of the silane monomer is controlled, so that a pressure of the silane monomer gas is controlled between 0.001 MPa to 0.003 MPa.

According to some embodiments, the hydrocarbon monomer has a flow rate of 10 sccm to 200 sccm, and the silane monomer has a flow rate of 5 sccm to 100 sccm.

According to some embodiments, an inert gas is introduced at a flow rate of 20 sccm to 200 sccm while the monomer gases are introduced.

According to some embodiments, the plasma reactor has a pressure of 15 mT to 100 mT therein, the bias voltage has an input of -200 V to -800 V, and the coating is deposited for a time of 2 min to 30 min.

Embodiments of the present disclosure further provide a composite coating, which includes the above DLC coating and an AF coating formed on the DLC coating.

According to some embodiments, the AF coating is made of a raw material including a polymer of perfluoropolyether.

According to some embodiments, the polymer of perfluoropolyether may be a perfluoropolyether silane or a perfluoropolyether alkoxysilane.

According to some embodiments, the AF coating has a thickness of 5 nm to 20 nm.

According to some embodiments, the AF coating is formed by deposition through a method of vacuum evaporation.

Embodiments of the present disclosure further provide a coated product, which has at least a part of a surface thereof coated with the above composite coating.

According to some embodiments, the product is a touch panel.

According to some embodiments, the coated product has a difference value below 0.5 between color differences before and after coating.

According to some embodiments, a coated surface of the product has a substrate of glass, and has a water drop contact angle above 100° observed according to a steel wool test performed with a test stroke of 40 mm at a rate of 40 cycle/min along a direction consistent with a fiber direction of the steel wool for 6000 reciprocating cycles under a load of 10 N.

According to some embodiments, a coated surface of the product has a substrate of plastic, and has a water drop contact angle above 100° observed according to a steel wool test performed with a test stroke of 40 mm at a rate of 40 cycle/min along a direction consistent with a fiber direction of the steel wool for 800 reciprocating cycles under a load of 1 N.

The DLC coating according to embodiments of the present disclosure is formed from a hydrocarbon monomer and a silane monomer by deposition through a PECVD method, and may be formed by reacting and depositing at room temperature, which effectively avoids influence of relatively high temperature on performance of a substrate in a conventional coating method. Further, the DLC coating formed according to embodiments of the present disclosure has properties of low color difference, high transparency and high bond strength, and is prepared by a simple method, which is conducive to process production. In addition, the anti-fingerprint composite coating obtained by depositing the AF coating on the DLC coating has properties of low color difference, high transparency and more scratch resistance, and is especially applicable to touch panels and other coated products.

BRIEF DESCRIPTION OF THE DRAWINGS

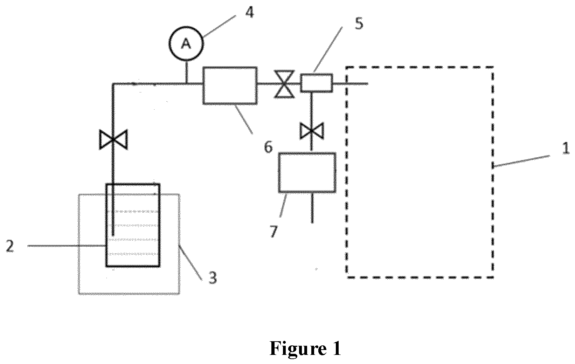

Figure 1 is a schematic view of a device for preparing a DLC coating according to an embodiment of the present disclosure.

DETAILED DESCRIPTION

Embodiments of the present disclosure provide a DLC coating formed from a hydrocarbon monomer with a formula of $C_{x1}H_{y1}$ and a silane monomer with a formula of $C_{x2}H_{y2}Si_z$ by deposition through a PECVD method, and, x1 is an integer from 1 to 10, y1 is an integer from 2 to 22, x2 is an integer from 0 to 32, y2 is an integer from 4 to 68, and z is an integer from 1 to 4.

The DLC coating according to embodiments of the present disclosure has element silicon doped using a PECVD method, and may be formed by reacting and depositing at room temperature, which effectively avoids influence of relatively high temperature on performance of a substrate in a conventional coating method. For example, the DLC coating may be well applicable to PC, PMMA and other polymer materials that are typically used in touch panels. Additionally, silicon doping technology is innovatively applied to touch panels, this can eliminate a phenomenon that DLC is easy to yellowing and discoloration.

In some embodiments, the hydrocarbon monomer and the silane monomer have boiling points below 100 °C at atmospheric pressure. By using the monomers with boiling points below 100 °C, vaporization state of the monomers can be easily controlled, so that ratio between the hydrocarbon monomer and the silane monomer can be more accurately and continuously controlled by controlling flow rates of gas monomers, and thus, ratio among carbon, hydrogen and silicon in the DLC is accurately controlled. As a result, hardness, low color difference and high transparency properties of the DLC coating are better ensured.

In some embodiments, x1 is an integer of 1 to 4, y1 is an integer of 2 to 10, x2 is an integer of 0 to 16, y2 is an integer of 4 to 36, and z is 1.

In some embodiments, the hydrocarbon monomer may be one or more selected from a group consisting of an alkyne, such as, acetylene or propylene, or the like; an olefin, such as, ethylene or propylene, or the like; an alkane, such as, methane, ethane or propane, or the like; and an aromatic hydrocarbon, such as, benzene.

In some embodiments, a molar ratio between the hydrocarbon monomer and the silane monomer may be 60:40 to 95:5, and specifically, 60:40, 65:35, 70:30, 75:25, 80:20, 85:15, 90:10, or 95:5, or the like.

In some embodiments, the DLC coating may have a thickness of 5 nm to 100 nm, and specifically, of 5 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, or 100nm, or the like.

Embodiments of the present disclosure further provide an apparatus for preparing the above DLC coating, which includes:

a plasma reactor for forming a DLC coating by deposition through a PECVD method;

a monomer vaporization control device for heating to vaporize the hydrocarbon monomer in liquid form at room temperature or controlling a vaporization state of the silane monomer;

a gas flowmeter for metering a flow rate of the monomers that have been vaporized in a controlled manner; and

a thermal insulation device for insulating a flow line of the monomers to ensure that a vaporized monomer in the monomer vaporization control device may be stably introduced into the plasma reactor.

The apparatus for preparing the DLC coating according to the embodiments of the present disclosure will be further explained with reference to Figure 1. As shown in Figure 1, which is a schematic view of a device for preparing a DLC coating according to an embodiment of the present disclosure, the apparatus for preparing the DLC coating according to the embodiments of the present disclosure includes:

a plasma reactor 1 for forming a DLC coating by deposition through a PECVD method;

a monomer vaporization control device for heating to vaporize the hydrocarbon monomer in liquid form at room temperature or controlling a vaporization state of the silane monomer;

a first gas flowmeter 6 for accurately metering a flow rate of the monomers that have been vaporized in a controlled manner; and a thermal insulation device for insulating a flow line of the monomers to ensure that a vaporized monomer is in a vaporized state during being introduced into the plasma reactor 1.

In some embodiments, the monomer vaporization control device includes a monomer container 2 and a temperature control device 3. In some embodiments, the monomer container 2 may contain a monomer, which is a hydrocarbon monomer in liquid form at room temperature and may be vaporized by heating the monomer container 2 through the temperature control device 3, so that an amount of introduced hydrocarbon monomer in liquid form at room temperature may be accurately metered by the first gas flowmeter 6. In some embodiments, the monomer container 2 may contain a monomer as a silane monomer, and may be in an appropriate temperature state by virtue of the temperature control device 3, so that an amount of introduced silane monomer may be accurately metered by the first gas flowmeter 6. In some embodiments, the temperature control device 3 is a water bath device or an oil bath device.

In some embodiments, a pressure gauge 4 is provided between the monomer vaporization control device and the first gas flowmeter 6, so that a temperature of the monomer vaporization control device may be controlled based on a reading of the pressure gauge. For example, in some embodiments, the temperature of the temperature control device 3 may be adjusted by monitoring the pressure gauge 4, to control a pressure between 0.001 MPa to 0.003 MPa.

In some embodiments, the apparatus for preparing the DLC coating according to the embodiments of the present disclosure further includes a second gas flowmeter 7 for accurately metering and controlling a flow rate of the hydrocarbon monomer, such as, methane, ethylene, or acetylene, or the like in gas form at room temperature.

In some embodiments, there are a plurality of the hydrocarbon monomers in liquid form at room temperature and a plurality of the silane monomers, and a plurality of the corresponding monomer vaporization control devices and first gas flowmeters 6 are correspondingly provided.

In some embodiments, there are a plurality of the hydrocarbon monomers in gas form at room temperature, and a plurality of the corresponding second gas flowmeters 7 are correspondingly provided.

In some embodiments, the apparatus for preparing the DLC coating according to the embodiments of the present disclosure further includes another second gas flowmeter 7 for metering an introduced inert carrier gas, such as, helium, or argon, or the like.

In some embodiments, the apparatus for preparing the DLC coating according to the embodiments of the present disclosure further includes a gas mixing device 5 for mixing a plurality of monomer gases evenly before entering them into the plasma reactor 1.

The apparatus for preparing the DLC coating according to the embodiments of the present disclosure can accurately control a ratio between the monomers by means of controlling a flow rate of vaporized monomers, especially a flow rate of the vaporized monomer of silane, to accurately control a ratio among carbon, hydrogen and silicon in the DLC coating, in order to better ensure that the DLC coating has properties of hardness, low color difference and high transparency.

Embodiments of the present disclosure further provide a method for preparing the above DLC coating, which includes the following steps:

providing a substrate and placing it in a plasma reactor;

metering a gas of the hydrocarbon monomer and a gas of the silane monomer and introducing them into the plasma reactor, and turning on a bias power supply, to deposit the DLC coating on the substrate by a PECVD method.

In some embodiments, the substrate is made of a material including a metal, a ceramic, a plastic, or glass, or the like.

In some embodiments, the substrate is a touch panel.

In some embodiments, the substrate is cleaned, in order to further enhance a binding force between the plasma coating and the substrate. For example, in some embodiments, before coating the DLC, 0 sccm to 200 sccm of argon and/or 0 sccm to 200 sccm of oxygen are introduced, a pressure is controlled at 15 mT to 100 mT, and a bias power supply is turned on to feed a voltage of -300 V to -1000 V, to bombard and clean the substrate for 5 min to 20 min, so that oxides and other contaminants on a surface of the substrate are etched out, and an interface with high surface energy is formed, providing a good foundation for deposition of the DLC.

In some embodiments, for the hydrocarbon monomer in gas form at room temperature, an amount of introduced hydrocarbon monomer in gas form at room temperature may be directly accurately metered by the gas flowmeter; for the hydrocarbon monomer in liquid form at room temperature, an amount of introduced hydrocarbon monomer in liquid form at room temperature may be accurately metered by a gas flowmeter when the hydrocarbon monomer in liquid form at room temperature is heated to be vaporized in advance; and for the silane monomer, an amount of introduced silane monomer may be accurately measured by a gas flowmeter when a pressure of the silane monome is controlled between 0.001 MPa to 0.003 MPa by controlling a temperature thereof, so that a ratio between the monomers may be accurately controlled and thus a ratio among carbon, hydrogen and silicon in the DLC coating may be accurately controlled, and it may be better ensured that the DLC coating has properties of hardness, low color difference and high transparency.

In some embodiments, the hydrocarbon monomer has a flow rate of 10 sccm to 200 sccm, the silane monomer has a flow rate of 5 sccm to 100 sccm, and a molar ratio between the hydrocarbon monomer and the silane monomer is 60:40 to 95:5, and specifically, 60:40, 65:35, 70:30, 75:25, 80:20, 85:15, 90:10, or 95:5, or the like. A particular molar ratio between the hydrocarbon monomer and the silane monomer may controlled by adjusting according to material of the substrate, a specific hydrocarbon monomer and a specific silane monomer, and actual requirements, and the like.

In some embodiments, an inert gas, such as, argon, or neon, or the like, is introduced at a flow rate of 20 sccm to 200 sccm while the monomer gases are introduced.

In some embodiments, the plasma reactor has a pressure of 15 mT to 100 mT therein, the bias voltage has an input of -200 V to -800 V, and the coating is deposited for a time of 2 min to 30 min.

In the method for preparing the DLC coating according to the embodiments of the present disclosure, the hydrocarbon monomer and the silane monomer are as described above.

Embodiments of the present disclosure further provide a composite coating, which includes the above DLC coating and an AF coating formed on the DLC coating.

In the composite coating according to the embodiments of the present disclosure, the DLC coating doped with Si element provides a good connection point for the AF coating, which may eliminate a process for plating silica before the AF coating and also obtain excellent bond strength between the AF and a touch panel. In addition, the DLC coating has a hardness (~1500HV) great than a hardness of silicon dioxide (~1100HV), which may further improve mechanical durability of the AF coating, and significantly increase friction resistance effect of the AF coating.

In some embodiments, the AF coating has a raw material which is a commonly used raw material of an AF coating. For example, in some embodiments, the raw material of the AF coating is a fluorinated material, such as, a polymer of perfluoropolyether or other appropriate fluorinated materials. In some embodiments, the polymer of perfluoropolyether is a perfluoropolyether silane or a perfluoropolyether alkoxysilane. Specifically, in some embodiments, the polymer of perfluoropolyether may be UD509 manufactured by Daikin Industries, KY-178, KY-185, KY-1900 manufactured by Shin-Etsu Chemical Co., Ltd., or Fomblin manufactured by Solvay Corporation (SOLVAY), or the like.

In some embodiments, the AF coating has a thickness of 5 nm to 20 nm, and specifically, 5 nm, 10 nm, 15 nm, or 20 nm, or the like.

In some embodiments, the AF coating is formed by means of vacuum evaporation. In some embodiments, the AF coating can also be formed by other methods, such as, spraying and electroplating.

Embodiments of the present disclosure further provide a coated product, which has at least a part of a surface thereof coated with the above composite coating.

In some embodiments, the product is a touch panel, such as, a touch panel of a mobile phone, a tablet, a vehicle, a TV, or an LED, or the like. In some embodiments, the product is an electrical product, a building product or any other products that have requirements for transparency, scratch resistance or wear resistance.

In some embodiments, the coated product has a difference value below 0.5 between color differences before and after coating. In some embodiments, the coated product has a difference value below 0.4 between color differences before and after coating. In some embodiments, the coated product has a difference value below 0.3 between color differences before and after coating.

The coated product according to the embodiments of the present disclosure has excellent wear resistance. In some embodiments, a coated surface of the product has a substrate of glass, and has a water drop contact angle above 100° observed according to a steel wool test performed with a test stroke of 40 mm at a rate of 40 cycle/min along a direction consistent with a fiber direction of the steel wool for 6000 reciprocating cycles under a load of 10 N. In some embodiments, a coated surface of the product has a substrate of glass, and has a water drop contact angle above 100° observed according to a steel wool test performed with a test stroke of 40 mm at a rate of 40 cycle/min along a direction consistent with a fiber direction of the steel wool for 7000 reciprocating cycles under a load of 10 N. In some embodiments, a coated surface of the product has a substrate of glass, and has a water drop contact angle above 100° observed according to a steel wool test performed with a test stroke of 40 mm at a rate of 40 cycle/min along a direction consistent with a fiber direction of the steel wool for 8000 reciprocating cycles under a load of 10 N. In some embodiments, a coated surface of the product has a substrate of plastic, and has a water drop contact angle above 100° observed according to a steel wool test performed with a test stroke of 40 mm at a rate of 40 cycle/min along a direction consistent with a fiber direction of the steel wool for 800 reciprocating cycles under a load of 1 N. In some embodiments, a coated surface of the product has a substrate of plastic, and has a water drop contact angle above 100° observed according to a steel wool test performed with a test stroke of 40 mm at a rate of 40 cycle/min along a direction consistent with a fiber direction of the steel wool for 900 reciprocating cycles under a load of 1 N. In some embodiments, a coated surface of the product has a substrate of plastic, and has a water drop contact angle above 100° observed according to a steel wool test performed with a test stroke of 40 mm at a rate of 40 cycle/min along a direction consistent with a fiber direction of the steel wool for 1000 reciprocating cycles under a load of 1 N.

The present disclosure will be further described below through specific examples.

Examples

Description of test methods

A water drop contact angle of a coating was tested according to standard GB/T 30447-2013.

A light transmittance and a color difference of a coating are test by calculating according to the standard GB11186.3-1989 using KONICA spectrometer CM-5 with a light source of light source C. In the test results,

$$\Delta E = \sqrt{\Delta L^2 + \Delta a^2 + \Delta b^2}$$, ΔE represents a color difference, T represents a light transmittance; L, a, and b represent the three color channels in the Lab color model, and L represents luminance, a represents red-green, and b represents yellow-blue.

Abrasion resistance test was performed using a Taber5900 reciprocating friction machine and Bonstar #0000 steel wool on a glass substrate under a load of 10N/ on a plastic substrate under a load of 1 N with a test stroke of 40 mm at a rate of 40 cycle/min along a direction consistent with a fiber direction of the steel wool, and the number of times where the water drop contact angle is less than 100° was observed.

Example 1

A glass touch panel was purged on a surface thereof with dry nitrogen and placed into a vacuum chamber of a plasma reactor. Impurity gases were exhausted from the vacuum chamber by a vacuum pump unit. When the vacuum chamber had a vacuum pressure less than 0.05 mT, 100 sccm of argon was introduced therein, until the vacuum pressure was controlled at 30 mT. Then, a bias power supply was turned on to feed a voltage of -400V, to clean the substrate by bombarding, for 5 min. Thereafter, the power supply and the gas source were turn off, and at the same time, a water bath was opened and controlled to have a temperature of 26 °C, at which, a tetramethylsilane monomer was controlled to have a gas pressure value between 0.001 MPa to 0.003 MPa. In addition, gas flow valves were adjusted to control a flow rate of the tetramethylsilane monomer at 40 sccm, to control a flow rate of argon at 100 sccm, and to control a flow rate of methane at 80 sccm, to introduce these three gases into a gas mixer for mixing and then into the plasma reactor with a pressure controlled at 30 mT in the cavity thereof. Subsequently, the bias power supply was turned on to input a voltage of -300V, for a coating time of 10 min, to coat a layer of 20 nm DLC coating with high transparency and high hardness. And then, the power supply, gas sources and the vacuum pump unit were turn off in turn, and a door of the vacuum chamber of the plasma reactor was opened to take out the glass touch panel.

The above glass touch panel after the DLC coating was completed was put into an AF evaporation chamber. And then, the AF evaporation chamber was evacuated to $3.0 \times 10^{-3}$ Pa, to introduce a UD509AF liquid, to evaporate at current of 12A, for a time of 800 seconds, to evaporate a layer of 10 nm AF coating. Thereafter, the glass touch panel was taken out.

The above glass touch panel with the DLC coating and the AF coating deposited thereon sequentially was tested for a light transmittance, a color difference, and wear resistance, and the results are listed in Table 1 below.

Example 2

A light transmittance, a color difference, and wear resistance were tested in the same manner as in Example 1, except that a PC touch panel was used instead of the glass touch panel, oxygen was used in cleaning the substrate for a longer time of 20 min instead of argon. And, the results are listed in Table 1 below.

Example 3

A light transmittance, a color difference, and wear resistance were tested in the same manner as in Example 1, except that a PMMA touch panel was used instead of the glass touch panel, and the substrate is cleaned by etching for a shorter time of 2 min. And, the results are listed in Table 1 below.

Example 4

A light transmittance, a color difference, and wear resistance were tested in the same manner as in Example 1, except that the water bath was controlled to have a temperature of 10 °C, and a trimethylsilane monomer was used instead of the tetramethylsilane monomer. And, the results are listed in Table 1 below.

Comparative example 1

A glass touch panel was purged on a surface thereof with dry nitrogen and placed into a vacuum chamber of a plasma reactor. Impurity gases were exhausted from the vacuum chamber by a vacuum pump unit. When the vacuum chamber had a vacuum pressure less than 0.05 mT, 100 sccm of argon was introduced therein, until the vacuum pressure was controlled at 30 mT. Then, a bias power supply was turned on to feed a voltage of -400 V, to clean the substrate by bombarding, for 5 min. Thereafter, the substrate was taken out to spray with a layer of 20 nm silica coating and a layer of 10 nm UD509AF coating on a surface thereof by a conventional spraying method. Subsequently, the coated glass touch panel was tested for a light transmittance, a color difference, and wear resistance, and the results are listed in Table 1 below.

Comparative example 2

A glass touch panel was purged on a surface thereof with dry nitrogen and placed into a vacuum chamber of a plasma reactor. Impurity gases were exhausted from the vacuum chamber by a vacuum pump unit. When the vacuum chamber had a vacuum pressure less than 0.05 mT, 100 sccm of argon was introduced therein, until the vacuum pressure was controlled at 30 mT. Then, a bias power supply was turned on to feed a voltage of -400 V, to clean the substrate by bombarding, for 5 min. Thereafter, the substrate was taken out and put into an evaporation chamber. And, the evaporation chamber was first evacuated to a base pressure below $4.0\times10^{-3}$ Pa, and then applied with current of 30A to a silica loaded evaporation boat thereof, for a time of 120 seconds, to evaporate a layer of 20 nm silica coating. Thereafter, the evaporation chamber was evacuated to $3.0\times10^{-3}$ Pa, and UD509AF liquid was introduced into another evaporation boat at current of 12 A, for a time of 800 seconds, to evaporate a layer of 10 nm AF coating. Subsequently, the glass touch panel was taken out. The coated glass touch panel was tested for a light transmittance, a color difference and wear resistance, and the results are listed in Table 1 below.

Comparative example 3

A light transmittance, a color difference, and wear resistance were tested in the same manner as in Example 1, except that the tetramethylsilane monomer was at a flow rate of zero, for a longer coating time of 15 min, to coat a layer of 20 nm DLC coating. And, the results are listed in Table 1 below.

Comparative example 4

A light transmittance was tested on a glass touch panel, which was only purged with dry nitrogen and not coated with a coating, and the results are listed in Table 1 below.

Comparative example 5

A light transmittance was tested on a PC touch panel, which was only purged with dry nitrogen and not coated with a coating, and the results are listed in Table 1 below.

Comparative example 6

Alight transmittance was tested on a PMMA touch panel, which was only purged with dry nitrogen and not coated with a coating, and the results are listed in Table 1 below.

Table 1. Results of property tests in Examples 1 to 4 and Comparative examples 1-6

|  | Light transmittances | Color differences ΔE | Wear resistance times |
|---|---|---|---|
| Example 1 | 91.4% | 0.2 | 8000 |
| Example 2 | 89.9% | 0.1 | 1000 |
| Example 3 | 92.5% | 0.2 | 1000 |
| Example 4 | 91.3% | 0.3 | 8000 |
| Comparative example 1 | 91.3 | 0.2 | 1000 |

(continued)

| | Light transmittances | Color differences ΔE | Wear resistance times |
|---|---|---|---|
| Comparative example 2 | 91.4% | 0.1 | 3000 |
| Comparative example 3 | 88.2% | 2.3 | 500 |
| Comparative example 4 | 91.5% | - | - |
| Comparative example 5 | 90% | - | - |
| Comparative example 6 | 92.7% | - | - |

According to the results in the above table 1, the coated glass touch panels in Examples 1 and 4 have light transmittances substantially the same as the light transmittance of the uncoated glass touch panel in Comparative example 4, the coated PC touch panel in Example 2 has a light transmittance substantially the same as the light transmittance of the uncoated PC touch panel in Comparative example 5, and the coated PMMA touch panel in Example 3 has a light transmittance substantially the same as the light transmittance of the uncoated PMMA touch panel in Comparative example 6, which demonstrate that the DLC coating and composite coating according to the present disclosure have excellent light transmittance. Additionally, the wear resistance times in Example 1 are much higher than the those in Comparative examples 1 and 2, which demonstrates that the composite coating according to the present disclosure has more excellent scratch resistance than the composite coatings in Comparative examples 1 and 2. Compared with Example 1, the DLC coating in Comparative example 3 is not doped with Si by introducing with the tetramethylsilane monomer, and has a significantly reduced light transmittance, a significantly improved color difference, and sharply reduced wear resistance times, which demonstrates that the composite coating obtained by depositing a AF coating on a DLC coating according to the present disclosure has properties of low color difference, high transparency and more scratch resistance.

Although the present disclosure is disclosed as above, the disclosure is not limited hereto. Various changes and modifications may be made by those skilled in the art without departing from the spirit and scope of the present disclosure. Thus, the scope of protection of the present disclosure shall be subject to the scope defined by the claims.

## Claims

1. A DLC coating, **characterized by** being formed from a hydrocarbon monomer with a formula of $C_{x1}H_{y1}$ and a silane monomer with a formula of $C_{x2}H_{y2}Si_z$ by deposition through a PECVD method, wherein, x1 is an integer from 1 to 10, y1 is an integer from 2 to 22, x2 is an integer from 0 to 32, y2 is an integer from 4 to 68, and z is an integer from 1 to 4.

2. The DLC coating according to claim 1, **characterized in that** the hydrocarbon monomer and the silane monomer have boiling points below 100 °C at atmospheric pressure.

3. The DLC coating according to claim 2, **characterized in that** the hydrocarbon monomer is methane, acetylene, benzene or ethylene.

4. The DLC coating according to claim 2, **characterized in that** the silane monomer is silicon tetrahydride, methylsilane, dimethylsilane, trimethylsilane, tetramethylsilane, ethyl silane or diethylsilane.

5. The DLC coating according to claim 1, **characterized in that** the hydrocarbon monomer has a molar ratio of 60:40 to 95:5 to the silane monomer.

6. The DLC coating according to claim 1, **characterized in that** the DLC coating has a thickness of 5 nm to 100 nm.

7. An apparatus for preparing the DLC coating according to any one of claims 1 to 6, **characterized by** comprising:

   a plasma reactor for forming a DLC coating by deposition through a PECVD method;
   a monomer vaporization control device for heating to vaporize the hydrocarbon monomer in liquid form at room temperature or controlling a vaporization state of the silane monomer;
   a gas flowmeter for metering a flow rate of the monomers that have been vaporized in a controlled manner; and
   a thermal insulation device for insulating a flow line of the monomers to ensure that a vaporized monomer in the monomer vaporization control device may be stably introduced into the plasma reactor.

8. The apparatus for preparing the DLC coating according to claim 7, **characterized by** further comprising a pressure gauge provided between the monomer vaporization control device and the gas flowmeter, and a temperature of the monomer vaporization control device is controlled based on a reading of the pressure gauge.

9. A method for preparing the DLC coating according to any one of claims 1 to 6, **characterized by** comprising the following steps:

providing a substrate and placing it in a plasma reactor;
metering a gas of the hydrocarbon monomer and a gas of the silane monomer and introducing them into the plasma reactor, and turning on a bias power supply, to deposit the DLC coating on the substrate by a PECVD method.

10. The method for preparing the DLC coating according to claim 9, **characterized in that** the hydrocarbon monomer and the silane monomer are respectively metered by the gas flowmeter and introduced in a form of gas.

11. The method for preparing the DLC coating according to claim 10, **characterized in that** a temperature of the silane monomer is controlled, so that a pressure of the silane monomer gas is controlled between 0.001 MPa to 0.003 MPa.

12. The method for preparing the DLC coating according to claim 10, **characterized in that** the hydrocarbon monomer has a flow rate of 10 sccm to 200 sccm, and the silane monomer has a flow rate of 5 sccm to 100 sccm.

13. The method for preparing the DLC coating according to claim 10, **characterized in that** an inert gas is introduced at a flow rate of 20 sccm to 200 sccm while the monomer gases are introduced.

14. The method for preparing the DLC coating according to claim 10, **characterized in that** the plasma reactor has a pressure of 15 mT to 100 mT therein, the bias voltage has an input of -200 V to -800 V, and the coating is deposited for a time of 2 min to 30 min.

15. A composite coating, **characterized by** comprising the DLC coating according to any one of claims 1 to 6 and an AF coating formed on the DLC coating.

16. The composite coating according to claim 15, **characterized in that** the AF coating is made of a raw material comprising a polymer of perfluoropolyether.

17. The composite coating according to claim 16, **characterized in that** the polymer of perfluoropolyether is a perfluoropolyether silane or a perfluoropolyether alkoxysilane.

18. The composite coating according to claim 15, **characterized in that** the AF coating has a thickness of 5 nm to 20 nm.

19. The composite coating according to claim 15, **characterized in that** the AF coating is formed by deposition through a method of vacuum evaporation.

20. A coated product, **characterized by** having at least a part of a surface thereof coated with the composite coating according to any one of claims 15 to 19.

21. The coated product according to claim 20, **characterized in that** the product is a touch panel.

22. The coated product according to claim 20, **characterized by** having a difference value below 0.5 between color differences before and after coating.

23. The coated product according to claim 20, **characterized in that** a coated surface of the product has a substrate of glass, and has a water drop contact angle above 100° observed according to a steel wool test performed with a test stroke of 40 mm at a rate of 40 cycle/min along a direction consistent with a fiber direction of the steel wool for 6000 reciprocating cycles under a load of 10 N.

24. The coated product according to claim 20, **characterized in that** a coated surface of the product has a substrate of plastic, and has a water drop contact angle above 100° observed according to a steel wool test performed with a test stroke of 40 mm at a rate of 40 cycle/min along a direction consistent with a fiber direction of the steel wool for 800 reciprocating cycles under a load of 1 N.

**Figure 1**

| INTERNATIONAL SEARCH REPORT | International application No. |
|---|---|
| | **PCT/CN2023/081532** |

**A. CLASSIFICATION OF SUBJECT MATTER**

C23C16/513(2006.01)i; C23C16/52(2006.01)i

According to International Patent Classification (IPC) or to both national classification and IPC

**B. FIELDS SEARCHED**

Minimum documentation searched (classification system followed by classification symbols)

IPC:C23C

Documentation searched other than minimum documentation to the extent that such documents are included in the fields searched

Electronic data base consulted during the international search (name of data base and, where practicable, search terms used)

EPTXT, DWPI, USTXT, VEN, WOTXT, SIPOABS, WEB OF SCIENCE, CNABS, CNTXT, CNKI: 类金刚石, 涂层, 甲烷, 乙炔, 苯, 乙烯, 硅烷, PEVCD, DLC, +coat, methane, acetylene, benzene, ethylene, silane.

**C. DOCUMENTS CONSIDERED TO BE RELEVANT**

| Category* | Citation of document, with indication, where appropriate, of the relevant passages | Relevant to claim No. |
|---|---|---|
| X | KR 20160049110 A (KOREA PHOTONICS TECHNOLOGY INSTITUTE) 09 May 2016 (2016-05-09) description, paragraphs 32-36, and figure 1 | 1-14 |
| X | US 5508368 A (DIAMONEX INC.) 16 April 1996 (1996-04-16) description, column 8, lines 36-64, column 16, line 41 to column 17, line 2 | 1-14 |
| X | J.C. Damascenoa. et al. "Deposition of Si-DLC films with High Hardness, Low Stress and High Deposition Rates" *Surface and Coatings Technology,* 30 November 2000 (2000-11-30), page 248, section 2 | 1-14 |
| Y | KR 20160049110 A (KOREA PHOTONICS TECHNOLOGY INSTITUTE) 09 May 2016 (2016-05-09) description, paragraphs 32-36, and figure 1 | 15-24 |
| Y | US 5508368 A (DIAMONEX INC.) 16 April 1996 (1996-04-16) description, column 8, lines 36-64, column 16, line 41 to column 17, line 2 | 15-24 |

☑ Further documents are listed in the continuation of Box C. ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **21 May 2023** | **06 June 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/081532**

**C.     DOCUMENTS CONSIDERED TO BE RELEVANT**

| Category* | Citation of document, with indication, where appropriate, of the relevant passages | Relevant to claim No. |
|---|---|---|
| Y | J.C. Damascenoa. et al. "Deposition of Si-DLC films with High Hardness, Low Stress and High Deposition Rates" *Surface and Coatings Technology*, 30 November 2000 (2000-11-30), page 248, section 2 | 15-24 |
| Y | CN 110582471 A (CORNING INC.) 17 December 2019 (2019-12-17) description, paragraph 9 | 15-24 |
| Y | US 6582823 B1 (NORTH CAROLINA STATE UNIVERSITY) 24 June 2003 (2003-06-24) description, column 1, line 42 to column 2, line 25 | 15-24 |
| A | CN 1827845 A (NORTHEASTERN UNIVERSITY) 06 September 2006 (2006-09-06) entire document | 1-24 |
| A | CN 110914468 A (SAINT-GOBAIN GLASS FRANCE S.A.) 24 March 2020 (2020-03-24) entire document | 1-24 |

Form PCT/ISA/210 (second sheet) (July 2022)

**INTERNATIONAL SEARCH REPORT**
Information on patent family members

International application No.

**PCT/CN2023/081532**

| Patent document cited in search report | | | Publication date (day/month/year) | Patent family member(s) | | | Publication date (day/month/year) |
|---|---|---|---|---|---|---|---|
| KR | 20160049110 | A | 09 May 2016 | None | | | |
| US | 5508368 | A | 16 April 1996 | EP | 0748260 | A1 | 18 December 1996 |
| | | | | EP | 0748260 | A4 | 15 July 1998 |
| | | | | EP | 0748260 | B1 | 14 May 2003 |
| | | | | EP | 0748260 | B2 | 28 October 2009 |
| | | | | USRE | 37294 | E | 24 July 2001 |
| | | | | DE | 69530758 | D1 | 18 June 2003 |
| | | | | DE | 69530758 | T2 | 27 November 2003 |
| | | | | DE | 69530758 | T3 | 31 December 2009 |
| | | | | AT | 240162 | T | 15 May 2003 |
| | | | | JPH | 10500633 | A | 20 January 1998 |
| | | | | JP | 3837159 | B2 | 25 October 2006 |
| | | | | WO | 9523652 | A1 | 08 September 1995 |
| CN | 110582471 | A | 17 December 2019 | US | 2018304322 | A1 | 25 October 2018 |
| | | | | US | 10413948 | B2 | 17 September 2019 |
| | | | | TW | 201841856 | A | 01 December 2018 |
| | | | | WO | 2018200468 | A1 | 01 November 2018 |
| | | | | VN | 68356 | A | 30 January 2020 |
| | | | | CN | 110582471 | B | 03 June 2022 |
| US | 6582823 | B1 | 24 June 2003 | AU | 4467400 | A | 17 November 2000 |
| | | | | WO | 0066353 | A1 | 09 November 2000 |
| | | | | WO | 0066353 | A8 | 01 November 2001 |
| CN | 1827845 | A | 06 September 2006 | CN | 100467664 | C | 11 March 2009 |
| CN | 110914468 | A | 24 March 2020 | EP | 3658697 | A1 | 03 June 2020 |
| | | | | WO | 2019020481 | A1 | 31 January 2019 |
| | | | | RU | 2751017 | C1 | 07 July 2021 |
| | | | | KR | 20200034773 | A | 31 March 2020 |
| | | | | US | 2020208257 | A1 | 02 July 2020 |
| | | | | IN | 202017002871 | A | 21 February 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210395178